(19) Europäisches Patentamt
European Patent Office
Office européen des brevets

(11) EP 0 981 558 B1

(12) # EUROPÄISCHE PATENTSCHRIFT

(45) Veröffentlichungstag und Bekanntmachung des Hinweises auf die Patenterteilung:
**17.08.2005 Patentblatt 2005/33**

(21) Anmeldenummer: **98922796.2**

(22) Anmeldetag: **04.05.1998**

(51) Int Cl.[7]: **C08F 246/00**, C09K 19/38, C07C 255/65, C07C 245/08

(86) Internationale Anmeldenummer:
**PCT/EP1998/002618**

(87) Internationale Veröffentlichungsnummer:
**WO 1998/051721 (19.11.1998 Gazette 1998/46)**

(54) **HOMOPOLYMERE MIT HOHER PHOTOINDUZIERBARER DOPPELBRECHUNG**
HOMOPOLYMERS WITH HIGH PHOTOINDUCEABLE DOUBLE REFRACTION
HOMOPOLYMERES A BIREFRINGENCE PHOTOINDUCTIBLE ELEVEE

(84) Benannte Vertragsstaaten:
**BE CH DE ES FR GB IT LI NL SE**

(30) Priorität: **15.05.1997 DE 19720288**

(43) Veröffentlichungstag der Anmeldung:
**01.03.2000 Patentblatt 2000/09**

(73) Patentinhaber: **Bayer MaterialScience AG
51368 Leverkusen (DE)**

(72) Erfinder:
- **BERNETH, Horst
D-51373 Leverkusen (DE)**
- **CLAUSSEN, Uwe
D-51379 Leverkusen (DE)**
- **KOSTROMINE, Serguei
D-58918 Swisttal (DE)**
- **NEIGL, Ralf
D-51373 Leverkusen (DE)**
- **VEDDER, Hans-Joachim
D-82178 Puchheim (DE)**

(56) Entgegenhaltungen:
**GB-A- 2 255 336 US-A- 4 631 328**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft photoadressierbare Seitengruppenpolymere, in denen sich durch Bestrahlung eine hohe Doppelbrechung induzieren läßt, so daß sie sich zur Speicherung optisch angebotener Information oder als passive oder optisch schaltbare Komponenten eignen.

Aus der Literatur sind verschiedene Polymere mit photochromen Gruppen bekannt; ihre besondere Eigenart ist, daß ihre optischen Eigenschaften wie Absorption, Emission, Reflexion, Doppelbrechung, Streuung lichtinduziert reversibel verändert werden können. Derartige Polymere haben eine spezielle verzweigte Struktur: An einem linearen Rückgrat sitzen - über als Abstandhalter wirkende Molekülteile verbunden - Seitengruppen, die elektromagnetische Strahlung absorbieren können. In der letzten Zeit hat sich das Interesse der Fachwelt auf solche Seitengruppenpolymere gerichtet, die Seitengruppen unterschiedlicher Art tragen, von denen eine Art elektromagnetische Strahlung absorbieren kann, während die andere Art eine mesogene, formanisotrope Gruppe ist. Flüssigkristalline Seitengmppenpolymere dieser Art werden z.B. in den US-PS 4 631 328 und 4 943 617 beschrieben. Filme aus diesen Polymeren sind im ungerichteten Zustand lichtstreuend und trüb; erst durch Ausrichtung werden diese Filme klar und transparent.

Aus den DE-OS 38 10 722 und US-PS 5 173 381 sind amorphe zur optischen Informationsspeicherung geeignete Polymere bekannt. Sie besitzen den technischen Vorteil, daß Filme aus diesen Polymeren sofort nach ihrer Herstellung gebrauchsfähige optische Eigenschaften aufweisen.

Homopolymere werden in diesem Zusammenhange selten erwähnt. In der EP-A 617 110 werden z.B. azohaltige Carbaminate beschrieben, die durch N-Acylierung mit (Meth)acrylsäure polymerisierbar gemacht wurden. In der Tat sind Homopolymere in aller Regel den Copolymeren technisch unterlegen.

Bisher sind nur Verfahren zur reversiblen Speicherung von Informationen beschrieben worden, wobei die Löschung durch Temperaturerhöhung geschieht, die sowohl als Wärme als auch durch Licht hervorgerufen werden kann. Die Löschung mit Licht kann darüber hinaus den Vorteil bieten, daß der Prozeß lokal begrenzt verläuft, weswegen diese Variante bevorzugt wird. Generell kann man feststellen, daß bei Temperaturerhöhung die Eigenschaft, Informationen gespeichert zu halten, verloren geht. Die bekannten Verbindungen besitzen also den Nachteil, daß die eingeschriebenen Doppelbrechungen nicht temperaturstabil sind; bei höheren Temperaturen, insbesondere bei Annäherung an die Glasübergangstemperatur, wird die Doppelbrechung schwächer und verschwindet schließlich ganz. Es besteht also ein Bedarf an Informationsträgern, bei denen die Stabilität der eingeschriebenen Information möglichst temperaturunempfindlich ist.

Überraschenderweise wurde nun gefunden, daß überlegene Seitenkettenpolymere, die sich zur Herstellung photoadressierbarer Informationsträger mit thermostabiler Informationsspeicherung eignen, dann entstehen, wenn man Monomere, die

- mindestens dreikernige Gruppierungen enthalten, die elektromagnetische Strahlung des sichtbaren Lichts absorbieren können und so gebaut sind, daß sie in thermodynamisch stabilem Zustand gestreckt und stark anisometrisch sind,

- wobei diese mindestens dreikernigen Gruppierungen mindestens einen, bevorzugt mindestens zwei, elektronenziehende(n) Substituenten besitzen, der/die ein Dipolmoment bewirkt/bewirken, das mit der Längsachse der mindestens dreikernigen Gruppierungen einen Winkel von mindestens 20, vorzugsweise mindestens 30° bildet, homopolymerisiert.

In diese neuen Polymeren lassen sich mit Licht thermostabile Graustufen einschreiben.

Grundsätzlich sind mindestens zwei Methoden zur Beeinflussung des Dipolmoments der mindestens dreikernigen Gruppierungen denkbar, nämlich

- die Substitution mit lateralen elektronenziehenden Substituenten, die in Bezug auf die Längsachse der Gruppierung unsymmetrisch angeordnet sind, und

- die Verwendung Kern-verbindender polarer Gruppen, deren Dipolmomente nicht in Richtung ihrer Längsachse zeigen.

Dabei sind Gruppen, die untereinander Wasserstoffbrücken bilden können, wie z.B. -NH-CO- und -OC-NH-, besonders bevorzugt.

Unter "elektromagnetischer Strahlung des sichtbaren Lichts" versteht man Licht des Wellenlängenbereiches von 350 bis 750 nm.

Unter "thermodynamisch stabilem Zustand" im Sinne der Erfindung versteht man die energieärmste Konfiguration, wie sie sich beispielsweise im Dunkeln in gelöstem Zustand in einem organischen Lösungsmittel einstellt.

Bei cis/trans-Isomerie, wie sie z.B. bei Stilbenen und Azoverbindungen vorkommt, ist jeweils das trans-Isomere das energieärmere Isomere. Welche Konfiguration vorliegt, läßt sich spektroskopisch anhand der Absorptionsbanden bestimmen.

Unter "gestreckt" im Sinne der Erfindung ist ein Zustand zu verstehen, wonach die mindestens dreikernigen Gruppierungen in einem Zylindcr mit einem Länge/Durchmesser-Verhältnis von 2,5, vorzugsweise von 3, Platz finden, wobei die Länge des Zylinders mit der Länge der mindestens dreikernigen Gruppierung identisch ist.

"Stark anisometrisch" im Sinne der Erfindung ist eine Struktur, wenn keiner der Kerne direkt oder indirekt (d. h. über eine verbindende kernlose Gruppe) mit dem übernächsten Kern verbunden ist, d.h. vorzugsweise (bei dreikernigen Gruppierungen) wenn der mittlere Kern ein 6-Ring ist, welcher über seine 1- und 4-Positionen mit den benachbarten Kernen direkt oder indirekt verbunden ist.

Unter "elektronenziehenden Substituenten" im Sinne der Erfindung werden Substituenten verstanden, die die Basizität, d.h. die Elektronendichte des Kerns, an dem sie sitzen, durch Induktions- und/oder Mesomerieeffekte verringern. Zu diesen Substituenten zählen vorzugsweise Alkylcarbonyl, Carboxyl, Alkoxycarbonyl, Carbamido, Carboxylamino, Cyano, Nitro, Ammonium und - weniger bevorzugt - die Halogene.

"Lateral" im Sinne der Erfindung bedeutet - am Beispiel einer Azobenzolgruppe erklärt - daß der Substituent einen Winkel mit der Längsachse des Azobenzols bildet, daß er also in o- und/oder m-Position steht, während ein Substituent in p-Position nicht als "lateral" im Sinne der Erfindung zu betrachten ist. Wird ein Phenylrest des Azobenzols beispielsweise durch einen Fünfring ersetzt, sind die Substituenten aller denkbaren Positionen an diesem Fünfring "lateral", weil es am Fünfring keine der p-Position am 6-Ring entsprechende Stellung gibt.

Als Kern-verbindende polare Gruppen, deren Dipolmomente mindestens 20° betragen, kommen prinzipiell alle Gruppen in Frage, die Carboxylgruppen enthalten. Am Beispiel der Amidgruppe läßt sich dies gut zeigen:

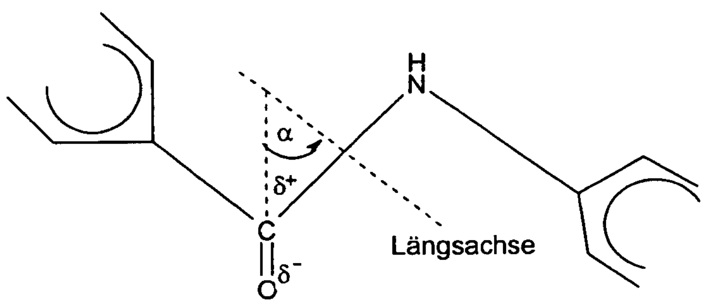


(II)

Die Richtung des Dipolmoments der Carboxylgruppe bildet mit der Längsachsse den Winkel $\alpha$, der mindestens 20° beträgt.

Gegenstand der Erfindung sind also Homopolymere aus Monomeren der Formel

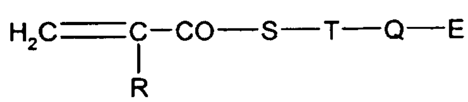

mit R = H oder Methyl,

die an einer als Rückgrat wirkenden Hauptkette davon abzweigende kovalent gebundene Seitengruppen der Formel

-S-T-Q-E

tragen, worin bedeuten:

S Sauerstoff, Schwefel oder $NR^1$,

$R^1$ Wasserstoff oder $C_1$-$C_4$-Alkyl,

T den Rest $(CH_2)_n$, der gegebenenfalls durch -O-, $-NR^1-$ oder $-OSiR^1{}_2O-$ unterbrochen und/oder gegebenenfalls durch Methyl oder Ethyl substituiert sein kann,

n die Zahlen 2, 3 oder 4,

Q einen zweibindigen Rest und

E eine mindestens dreikemige Gruppierung, wobei die Kerne ausgewählt sind aus der Gruppe von 2,6-Naphthylen, 1,4-Phenylen, heterocyclischen Resten der Strukturen

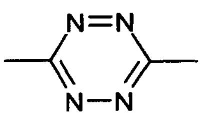 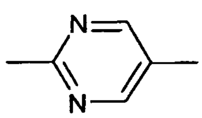 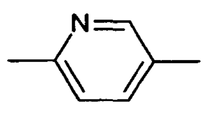 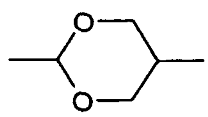

und 5-gliedrigen carbocyclischen oder heteroaromatischen Ringsystemen mit bis zu 3 Heteroatomen aus der Reihe S, N und O,
wobei die aromatischen Kerne ggf. durch $C_1$-$C_{12}$-Alkyl, $C_1$-$C_{12}$-Alkoxy, Hydroxy, Halogen (insbesondere F, Cl, Br), Amino, Nitro, Trifluormethyl, Cyan, Carboxy, COOR (R = $C_1$-$C_6$-Alkyl, Cyclohexyl, Benzyl, Phenyl), $C_5$-$C_{12}$-Cycloalkyl, $C_1$-$C_{12}$-Alkylthio, $C_1$-$C_6$-Alkylsulfonyl, $C_6$-$C_{12}$-Arylsulfonyl, Aminosulfonyl, $C_1$-$C_6$-Alkylaminosulfonyl, Phenylaminosulfonyl, Aminocarbonyl, $C_1$-$C_6$-Alkylaminocarbonyl, Phenylaminocarbonyl, $C_1$-$C_4$-Alkylamino, Di-$C_1$-$C_4$-alkylamino, Phenylamino, $C_1$-$C_5$-Acylamino, $C_1$-$C_4$-Alkylsulfonylamino, Mono- oder Di- $C_1$-$C_4$-alkylaminocarbonylamino, $C_1$-$C_4$-Alkoxycarbonylamino oder Trifluormethylsulfonyl ein- oder mehrfach substituiert sind und
die heterocyclischen Kerne ggf. durch $C_1$-$C_{12}$-Alkyl, $C_1$-$C_{12}$-Alkoxy, Hydroxy, Halogen (insbesondere F, Cl, Br), Amino, Nitro, Trifluormethyl, Cyan, Carboxy, COOR (R = $C_1$-$C_6$-Alkyl, Cyclohexyl, Benzyl, Phenyl), $C_5$-$C_{12}$-Cycloalkyl, $C_1$-$C_{12}$-Alkylthio, $C_1$-$C_6$-Alkylsulfonyl, $C_6$-$C_{12}$-Arylsulfonyl, Aminosulfonyl, $C_1$-$C_6$-Alkylaminosulfonyl, Phenylaminosulfonyl, Aminocarbonyl, $C_1$-$C_6$-Alkylaminocarbonyl, Phenylaminocarbonyl, $C_1$-$C_4$-Alkylamino, Di-$C_1$-$C_4$-alkylamino, Phenylamino, $C_1$-$C_5$-Acylamino, $C_1$-$C_4$-Alkylsulfonylamino, Mono- oder Di- $C_1$-$C_4$-alkylaminocarbonylamino, $C_1$-$C_4$-Alkoxycarbonylamino oder Trifluormethylsulfonyl ein- oder mehrfach substituiert sind, und mindestens eine für eine photoinduzierte Konfigurationsänderung geeignete Kern-verbindende Gruppe der Formel

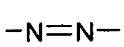, 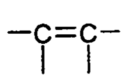, 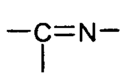, 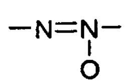 oder 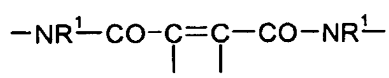

enthalten ist.

Bevorzugte mindestens dreikernige Gruppierungen sind solche, die mindestens zwei aromatische Kerne enthalten.
Die Funktion des Restes T besteht in der Gewährleistung eines bestimmten Abstandes des Seitengruppenendes von der als Rückgrat wirkenden Kette. Es wird deshalb auch "Spacer" genannt.
Der Rest Q verbindet die Endgruppe E mit dem Spacer T, der einerseits über das Verbindungsglied S die Verbindung zur Hauptkette herstellt. Das Besondere der Gruppe Q ist ihr Einfluß sowohl auf E einerseits als auch auf die Nachbargruppen andererseits.
Bevorzugte Reste Q umfassen die Gruppen -S-, $-SO_2-$, -O-, -COO-, -OCO-, $-CONR^1-$, $-NR^1-CO-$, $-NR^1-$ und $(CH_2)_m$ mit m = 1 oder 2.
Die mindestens dreikernigen Gruppierungen E enthalten mindestens eine Kern-verbindende Gruppe, die für eine photoinduzierte Konfigurationsänderung geeignet ist, wie z.B.

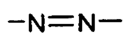 , 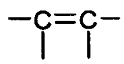 , 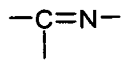 , 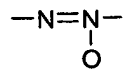 oder 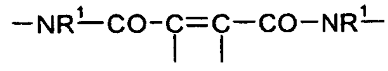

Die Gruppierungen E können neben mindestens einer der konfigurationsveränderlichen Gruppen auch andere Kern-verbindende Gruppen, wie z.B. -C≡C-, -COO-, -OCO-, -CONR$^1$-, -NR$^1$CO- oder eine Direktbindung enthalten, wobei R$^1$ = H bevorzugt ist und Direktbindungen weniger bevorzugt sind.

Die mindestens 3 Kerne von E können jeweils einen 5- oder 6-gliedrigen cycloaliphatischen Ring oder einen Naphthalinrest bedeuten mit der Maßgabe, daß mindestens zwei und vorzugsweise mindestens drei Kerne aromatisch sind.

5-Gliedrige Ringsysteme sind carbocyclisch oder - bevorzugt - heteroaromatisch und enthalten bis zu 3 Heteroatome aus der Reihe S, N, O,. Geeignete Vertreter sind beispielsweise Thiophen, Thiazol, Oxazol, Triazol, Oxadiazol und Thiadiazol. Heterocyclen mit 2 Heteroatomen sind besonders bevorzugt.

Bevorzugte Gruppierungen E enthalten z.B. Zimtsäure-, Stilben- und Azofarbstoffreste oder Analoga heterocyclischer Art, vorzugsweise Mono- und Diazofarbstoffreste.

Die Gruppierungen E sollen polarisiert sein. Wie oben beschrieben, kann diese Polarisierung durch Substitution mit elektronenziehenden lateralen Substituenten erfolgen. Bevorzugt sind Substituenten, deren σ-Wert nach Hammett wenigstens 0,5 beträgt. Die σ-Werte sind literaturbekannt; siehe beispielsweise C. Hansch, A. Leo, R.W. Taft, Chem. Rev. 1991, 91 (165-195). Sofern die Kerne mehrfach substituiert sind, richtet sich die Anzahl der Substituenten jeweils nach der Anzahl der möglichen Substitutionspositionen, der Möglichkeit des Einbaus der Substituenten und den Eigenschaften der substituierten Systeme. Bevorzugt sind die 2,4- und 3,4-Positionen an 6-gliedrigen Ringen; bevorzugte Substituenten sind Cyan und Nitro.

Für E geeignete aromatische Kerne enthalten vorzugsweise 6 bis 14 C-Atome im aromatischen Ring, der durch $C_1$-$C_{12}$-Alkyl, $C_1$-$C_{12}$-Alkoxy, Hydroxy, Halogen (insbesondere F, Cl, Br), Amino, Nitro, Trifluormethyl, Cyan, Carboxy, COOR (R = $C_1$-$C_6$-Alkyl, Cyclohexyl, Benzyl, Phenyl), $C_5$-$C_{12}$-Cycloalkyl, $C_1$-$C_{12}$-Alkylthio, $C_1$-$C_6$-Alkylsulfonyl, $C_6$-$C_{12}$-Arylsulfonyl, Aminosulfonyl, $C_1$-$C_6$-Alkylaminosulfonyl, Phenylaminosulfonyl, Aminocarbonyl, $C_1$-$C_6$-Alkylaminocarbonyl, Phenylaminocarbonyl, $C_1$-$C_4$-Alkylamino, Di-$C_1$-$C_4$-alkylamino, Phenylamino, $C_1$-$C_5$-Acylamino, $C_1$-$C_4$-Alkylsulfonylamino, Mono- oder Di- $C_1$-$C_4$-alkylaminocarbonylamino, $C_1$-$C_4$-Alkoxycarbonylamino oder Trifluormethylsulfonyl ein- oder mehrfach substituiert sein kann.

Für E geeignete heterocyclische Kerne enthalten vorzugsweise 5 bis 14 Ringatome, von denen 1 bis 4 Heteroatome aus der Reihe Stickstoff, Sauerstoff, Schwefel sind, wobei das heterocyclische Ringsystem durch $C_1$-$C_{12}$-Alkyl, $C_1$-$C_{12}$-Alkoxy, Hydroxy, Halogen (insbesondere F, Cl, Br), Amino, Nitro, Trifluormethyl, Cyan, Carboxy, COOR (R = $C_1$-$C_6$-Alkyl, Cyclohexyl, Benzyl, Phenyl), $C_5$-$C_{12}$-Cycloalkyl, $C_1$-$C_{12}$-Alkylthio, $C_1$-$C_6$-Alkylsulfonyl, $C_6$-$C_{12}$-Arylsulfonyl, Aminosulfonyl, $C_1$-$C_6$-Alkylaminosulfonyl, Phenylaminosulfonyl, Aminocarbonyl, $C_1$-$C_6$-Alkylaminocarbonyl, Phenylaminocarbonyl, $C_1$-$C_4$-Alkylamino, Di-$C_1$-$C_4$-alkylamino, Phenylamino, $C_1$-$C_5$-Acylamino, $C_1$-$C_4$-Alkylsulfonylamino, Mono- oder Di- $C_1$-$C_4$-alkylaminocarbonylamino, $C_1$-$C_4$-Alkoxycarbonylamino oder Trifluormethylsulfonyl ein- oder mehrfach substituiert sein kann.

Besonders bevorzugte Gruppierungen E enthalten folgende zweikernige Teilreste: entweder einen aromatischen Kern und einen heterocyclischen Kern oder zwei aromatische Kerne.

Bevorzugte zweikernige Teilreste sind Azobenzolreste der Formel

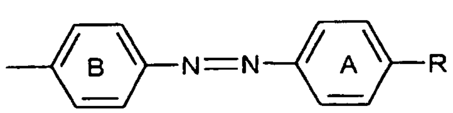 (III),

worin

R für eine Bindung oder für Nitro, vorzugsweise 4-substituiertes Benzamido oder Cyano, steht und die Ringe A und B zusätzlich substituiert sein können. Steht R für Cyan oder Nitro, ist Ring A vorzugsweise zusätzlich substituiert, wobei der Substituent einen σ-Wert von mindestens 0,5 haben soll.

Besonders bevorzugte Azobenzolreste entsprechen der Formel

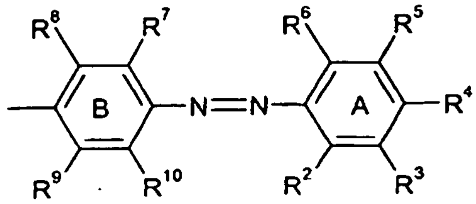

(IV),

worin

$R^2$ bis $R^6$ unabhängig voneinander für Wasserstoff, Chlor, Brom, Trifluormethyl, Methoxy, $SO_2CH_3$, $SO_2CF_3$, $SO_2NH_2$, vorzugsweise CN, 4-substituiertes Benzamido oder Nitro, stehen, vorzugsweise mit der Maßgabe, daß mindestens zwei dieser Reste ungleich Wasserstoff sind, wobei

$R^4$ zusätzlich eine Einfachbindung bedeuten kann und

$R^7$ bis $R^{10}$ unabhängig voneinander Wasserstoff, Chlor oder Methyl bedeuten.

Bei Mehrfachsubstitution des Rings A sind die 2,4- und 3,4-Positionen bevorzugt.

Andere zweikernige Teilreste entsprechen der Formel

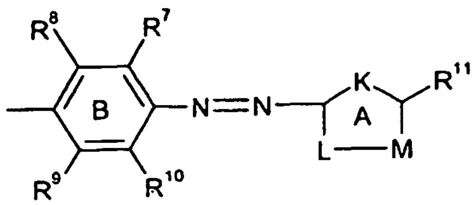

(VI)

worin

K, L, M unabhängig voneinander die Atome N, S, O oder gegebenenfalls $-CH_2-$ oder -CH= bedeuten mit der Maßgabe, daß mindestens eines der Glieder K, L, M ein Heteroatom ist und der Ring A gesättigt ist oder 1 oder 2 Doppelbindungen enthält, und

$R^2$ und $R^7$ bis $R^{10}$ unabhängig voneinander die oben angegebenen Bedeutungen besitzen.

Der Ring A steht vorzugsweise für einen Thiophen-, Thiazol-, Oxazol-, Triazol-, Oxadiazol- oder Thiadiazolrest.

Den obigen Formeln gemeinsam ist, dass Substitutionen in 4-, 2,4- und 3,4-Position des Ringes A besonders bevorzugt sind.

Besonders bevorzugte Gruppierungen E entsprechen den Formeln

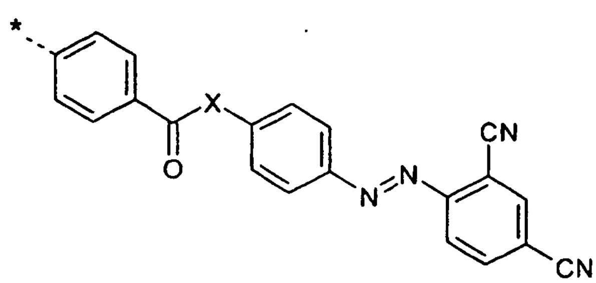

mit X = O oder $NR^1$

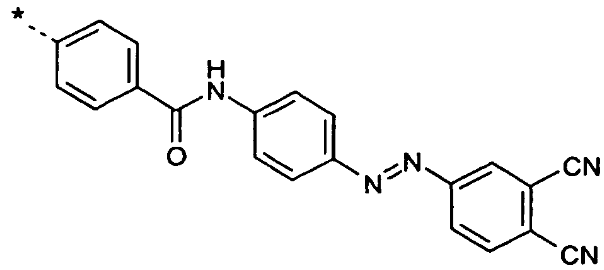

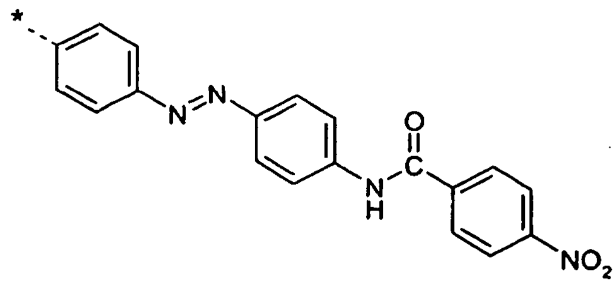

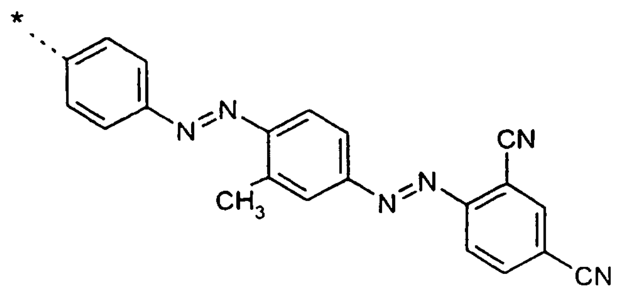

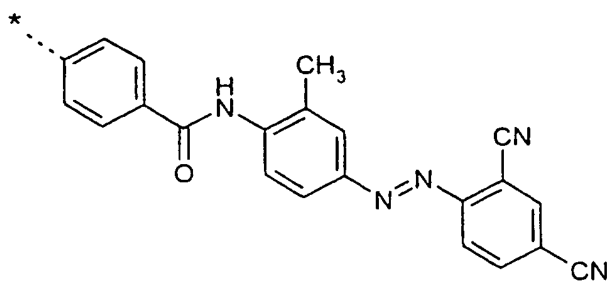

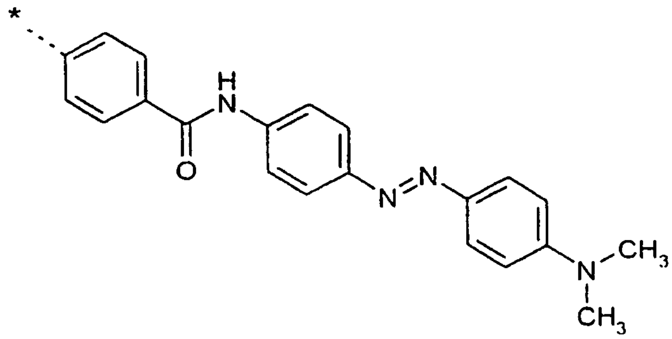

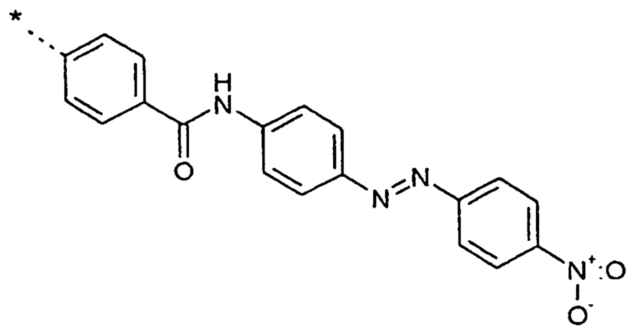

Die erfindungsgemäßen Polymeren enthalten allein wiederkehrende Einheiten mit den Seitengruppen I, und zwar vorzugsweise solche der Formel

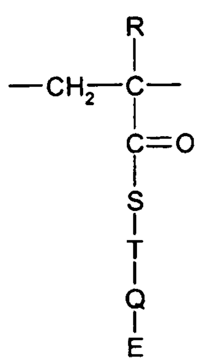

(VIII)

mit R = H oder - vorzugsweise - Methyl.

Die entsprechenden Monomeren zur Einführung der Seitengruppen I entsprechen also der Formel

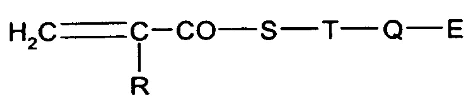

(IX)

Die Hauptkette der Seitengruppenpolymeren wird allein von Monomeren, die die Seitengruppen (I) tragen gebildet.

Die erfindungsgemäßen Polymeren besitzen vorzugsweise Glasübergangstemperaturen Tg von mindestens 40°C. Die Glasübergangstemperatur kann beispielsweise nach B. Vollmer, Grundriß der Makromolekularen Chemie,

S. 406 bis 410, Springer-Verlag, Heidelberg 1962, bestimmt werden.

Die erfindungsgemäßen Polymeren besitzen im allgemeinen ein als Gewichtsmittel bestimmtes Molekulargewicht von 3 000 bis 2 000 000, vorzugsweise 5 000 bis 1 500 000, bestimmt durch Gelpermeationschromatographie (geeicht mit Polystyrol).

Durch die Struktur der Polymeren werden die zwischenmolekularen Wechsetwirkungen der Strukturelemente (I) so eingestellt, daß die Ausbildung flüssigkristalliner Ordnungszustände unterdrückt wird und optisch isotrope, transparente nichtstreuende Filme hergestellt werden können. Andererseits sind die zwischenmolekularen Wechselwirkungen dennoch stark genug, daß bei Bestrahlung mit polarisiertem Licht ein photochemisch induzierter, kooperativer, gerichteter Umorientierungsprozeß der Seitengruppen bewirkt wird.

In die optisch isotropen, amorphen erfindungsgemäßen Polymeren lassen sich durch Bestrahlung mit polarisiertem Licht extrem hohe Werte der optischen Anisotropie induzieren. Die gemessenen Werte der Doppelbrechungsänderung $\Delta n$ liegen zwischen 0,05 und 0,8.

Als Licht wird vorzugsweise linear polarisiertes Licht verwendet, dessen Wellenlänge im Bereich der Absorptionsbande der Seitengruppen liegt.

Die Herstellung der Seitengruppenmonomeren und ihre Polymerisation können nach literaturbekannten Verfahren durchgeführt werden; vgl. beispielsweise Makromolekulare Chemie 185, 1327-1334 (1984), SU 887 574, Europ. Polym. J. 18, 651 (1982) und Liq. Cryst. 2, 195 (1987), DD 276 297, DE-OS 28 31 909 und 38 08 430. Die erfindungsgemäßen Polymeren werden im allgemeinen durch radikalische Polymerisation der Monomeren in geeigneten Lösungsmitteln, wie z.B. aromatischen Kohlenwasserstoffen wie Toluol oder Xylol, aromatischen Halogenkohlenwasserstoffen wie Chlorbenzol, Ethern wie Tetrahydrofuran oder Dioxan, Ketonen wie Aceton oder Cyclohexanon, und/oder Dimethylformamid in Gegenwart radikalliefernder Polymerisationsinitiatoren, wie z.B. Azobis(isobutyronitril) oder Benzoylperoxid, bei erhöhten Temperaturen, in der Regel bei 30 bis 130°C, vorzugsweise bei 40 bis 70°C, möglichst unter Wasser- und Luftausschluß hergestellt. Die Isolierung kann durch Ausfällen mit geeigneten Mitteln, z.B. Methanol erfolgen. Die Produkte können durch Umfällen, z.B. mit Chloroform/Methanol gereinigt werden.

Die Herstellung isotroper Filme gelingt, ohne daß aufwendige Oriemiemngsverfahren unter Nutzung externer Felder und/oder von Oberflächeneffekten notwendig sind. Sie lassen sich durch Spincoating, Tauchen, Gießen oder andere technologisch leicht beherrschbare Beschichtungsverfahren auf Unterlagen aufbringen, durch Pressen oder Einfließen zwischen zwei transparente Platten bringen oder einfach als selbsttragende Filme durch Gießen oder Extrudieren herstellen. Solche Filme lassen sich durch schlagartiges Abkühlen, d.h. durch eine Abkühlungsrate von > 100 K/min, oder durch rasches Abziehen des Lösungsmittels auch aus flüssig-kristallinen Polymeren herstellen, die Strukturelemente im beschriebenen Sinne enthalten.

Die Schichtdicke solcher Filme liegt vorzugsweise zwischen 0, 1 µm und 1 mm, insbesondcrs zwischen 0,1 und 100 µm.

Die erfindungsgemäßen Seitengruppenpolymeren sind im glasartigen Zustand der Polymeren optisch isotrop, amorph, transparent und nicht-lichtstreuend und können selbsttragende Filme bilden.

Vorzugsweise werden sie aber auf Trägermaterialien, beispielsweise Glas oder Kunststoffollen, aufgebracht. Dies kann durch verschiedene an sich bekannte Techniken geschehen, wobei das Verfahren danach ausgewählt wird, ob eine dicke oder dünne Schicht gewünscht wird. Dünne Schichten können z.B. durch Spincoaten oder Rakeln aus Lösungen oder der Schmelze, dickere durch Füllen von vorgefertigten Zellen, Schmelzpressen oder Extrudieren erzeugt werden.

Die Polymeren lassen sich zur digitalen oder analogen Datenspeicherung im weitesten Sinne, beispielsweise zur optischen Signalverarbeitung, zur Fourier-Transformation und -Faltung oder in der kohärenten optische Korrelationstechnik, verwenden. Die laterale Auflösung wird durch die Wellenlänge des Einschreibelichts begrenzt. Sie erlaubt eine Pixelgröße von 0,45 bis 3 000 µm, bevorzugt ist eine Pixelgröße von 0,5 bis 30 µm.

Diese Eigenschaft macht die Polymeren zur Verarbeitung von Bildern und zur Informationsverarbeitung mittels Hologrammen besonders geeignet, deren Reproduktion durch Ausleuchten mit einem Referenzstrahl erfolgen kann. Analog läßt sich das Interferenzmuster zweier monochromatischer kohärenter Lichtquellen mit konstanter Phasenbeziehung speichern. Entsprechend lassen sich dreidimensionale holographische Bilder speichern. Das Auslesen erfolgt durch Beleuchtung des Hologramms mit monochromatischem, kohärentem Licht. Durch den Zusammenhang zwischen dem elektrischen Vektor des Lichts und der damit verbundenen Vorzugsrichtung im Speichermedium läßt sich eine höhere Speicherdichte als bei einem rein binären System erzeugen. Bei der analogen Speicherung können Werte der Grauskala kontinuierlich und ortsaufgelöst eingestellt werden. Das Auslesen analog gespeicherter Information geschieht im polarisierten Licht, wobei man je nach Stellung der Polarisatoren das positive oder das negative Bild hervorholen kann. Hierbei kann einerseits der durch die Phasenverschiebung von ordentlichem und außerordentlichem Strahl erzeugte Kontrast des Films zwischen zwei Polarisatoren genutzt werden, wobei die Ebenen des Polarisators vorteilhaft einen Winkel von 45° zur Polarisationsebene des Einschreiblichts bilden und die Polarisationsebene des Analysators entweder senkrecht oder parallel zu der des Polarisators steht. Eine andere Möglichkeit besteht in der Detektion des durch induzierte Doppelbrechung verursachten Ablenkwinkels des Leselichts.

Die Polymeren lassen sich als optische Komponenten verwenden, die passiv sein oder aktiv schaltbar sein können, insbesondere für holografische Optiken. So kann die hohe lichtinduzierte optische Anisotropie zur elektrischen Modulierung der Intensität und/oder des Polarisationszustandes von Licht genutzt werden. Entsprechend kann man aus einem Polymerfilm durch holografische Strukturierung Komponenten herstellen, die Abbildungseigenschaften haben, die mit Linsen oder Gittern vergleichbar sind.
Weiterer Gegenstand der Erfindung ist also die Verwendung der beschriebenen Polymeren für optische Bauelemente.
Die Monomeren IX sind neu. Ein weiterer Gegenstand der Erfindung sind deshalb die Monomeren IX.
Die Monomeren IX können analog bekannten Reaktionen hergestellt werden, z.B. durch

A) Umsetzung von Säurechloriden der Formel

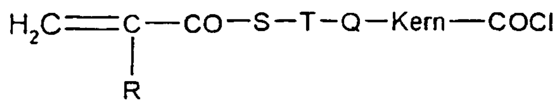

mit 4-Amino-Zweikern-Verbindungen, z.B. 4-Aminoazobenzolen, zu Monomer IX, z.B. der Verbindung des Beispiels 2.1.1;

B)

1. Kondensation von

   a) 1,4-Diaminokernen, z.B. 1,4-Phenylendiamin, mit

   b) Kernsäurechloriden, z.B. p-Nitrobenzoylchlorid, zu

   c) p-(Kern-carboxamino)-kernamin, z.B. N-(p-Nitrobenzoyl)-1,4-phenylendiamin,

2. Diazotierung von 1 c) und

3. Kupplung mit einer Verbindung

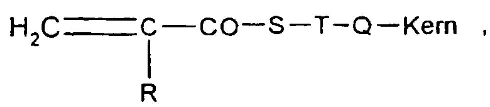

z.B. (Meth-)Acrylsäure-1-(N-methylanilino)-ethylester zum Monomer IX, z.B. der Verbindung des Beispiels 2.4;

C)

1. Diazotierung von 4-Aminozweikern, z.B. 4-Aminoazobenzol,
2. Kupplung mit dem (Meth-)Acrylsäureester

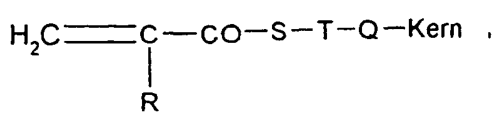

z.B. (Meth-)Acrylsäure-1-(N-methylanilino)-ethylester, zum Monomer IX, z.B. der Diazoverbindung des Beispiels 2.5.

Für die Reaktion A wird man pro Mol Säurechlorid vorzugsweise 1-1.2 Mol Aminozweikernverbindung einsetzen. Die Reaktion kann in Lösungsmittel stattfinden, wobei inerte organische Lösungsmittel, die Ether wie z.B. Dioxan umfassen, bevorzugt sind. Die Reaktion wird vorzugsweise bei Temperaturen von 20 bis 80°C durchgeführt.

Die Diazotierungen für die Reaktionen B und C können beispielsweise in Mineralsäuren, wie Salzsäure, Schwefelsäure, Phosphorsäure, oder in Carbonsäuren wie Essig- oder Propionsäure mit Natriumnitrit oder Nitrosylschwefelsäure als Nitrosierungsmittel bei Temperaturen von vorzugsweise -10 bis +20, insbesondere 0 bis +10°C, durchgeführt werden. In der Regel legt man dann die Kupplungskomponente, gegebenenfalls in einem geeigneten Lösungsmittel wie Eisessig oder Methanol, vor, stellt den pH-Wert auf 1 bis 6, vorzugsweise 3 bis 4 ein und hält die Temperatur während der Zugabe der Diazoniumkomponente bei 0 bis 30, vorzugsweise 5 bis 10°C. Dann neutralisiert man beispielsweise mit Natronlauge oder wäßriger Sodalösung, verdünnt mit Wasser und saugt das ausgefallene Produkt ab.

Die Prozentangaben in den nachfolgenden Beispielen beziehen sich - falls nicht anders angegeben - jeweils auf das Gewicht.

## Beispiele

**Beispiel 1** Herstellung der Polymerisate

1.1 Herstellung der Monomeren

$$H_2C = C(CH_3) - COO - CH_2- CH_2- Q - E$$

1.1.1.
Q = -O- ;

E =

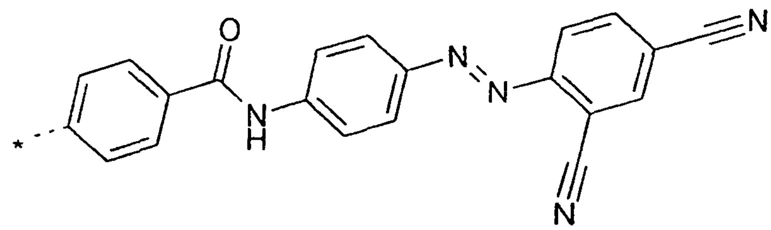

31,4 g 2,4-Dicyanoanilin werden bei 0 bis 5°C in 300 ml 50%-iger wäßriger Schwefelsäure mit 72 g Nitrosylschwefelsäure diazotiert und 1 h nachgerührt. Man gibt langsam die Reaktionsmischung zu einer Lösung von 20,4 g Anilin und 4,5 g Harnstoff in 300 ml 50%-iger wäßriger Schwefelsäure, wobei die Temperatur auf 0°C gehalten wird. Nach 1h Nachrühren wird die Reaktionsmischung mit Soda auf einen pH-Wert von 5,5 gestellt, der Niederschlag abgesaugt, mit Wasser gewaschen und getrocknet Man erhält 34 g rotes 4-Amino-2',4'-dicyano-azobenzol, das ohne Reinigung weiter verwendet wird.

Zu einer Lösung von 33 g 4-(2-Methacryloyloxy)-ethoxy-benzoesäurechlorid in 100 ml Dioxan werden 27,6 g 4-Amino-2',4'-dicyano-azobenzol in 500 ml Dioxan gegeben, 2 h gerührt und das Produkt durch Eingießen der Lösung in 2 1 Wasser gefällt. Der Niederschlag wird abgesaugt, getrocknet und durch zweimaliges Umkristallisieren aus Dioxan gereinigt. Die Ausbeute beträgt 30,4 g an orangeroten Kristallen mit einem Fp. von 215- 217°C. $\lambda_{max}$= 404,5 nm (DMF).

1.1.2
Q = -O- ;

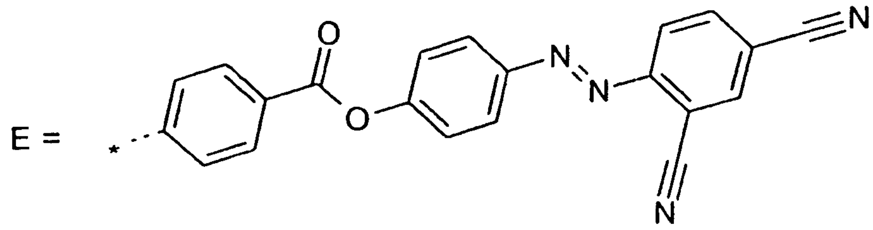

20,7 g 2,4-Dicyanoanilin werden bei 0 bis 5°C in einer Lösung aus 200 ml Eisessig, 40 ml 85%-iger Phosphorsäure und 7,5 ml konzentrierter Schwefelsäure mit 48 g Nitrosylschwefelsäure diazotiert und 1 h nachgerührt. Man gibt langsam die Reaktionsmischung zu einer Lösung von 16 g Phenol und 3 g Harnstoff in 120 ml Wasser, wobei die Temperatur auf 10°C und der pH-Wert mit Natronlauge auf 6,3-6,5 gehalten werden. Nach 1h Nachrühren wird der Niederschlag abgesaugt, mit Wasser gewaschen, getrocknet und aus Toluol umkristallisiert. Man erhält 30,3 g orangerotes 4-Hydroxy-2',4'-dicyano-azobenzol.

Zu einer Lösung von 16,6 g 4-Hydroxy-2',4'-dicyano-azobenzol und 11 ml Triethylamin in 400 ml THF wird die Lösung von 18,1 g 4-(2-Methacryloyloxy)-ethoxy-benzoesäurechlorid in 100 ml Diethylether langsam zugegeben, wobei die Temperatur auf 5°C gehalten wird. Man rührt bei Raumtemperatur über Nacht, versetzt danach die Reaktionslösung mit 500 ml Chloroform und schüttelt 5 mal mit je 300 ml Wasser aus. Die organische Phase wird über wasserfreiem Magnesiumsulfat getrocknet. Nach Abdestillieren des Lösungsmittels wird der feste Rückstand aus Ethanol umkristallisiert. Man erhält 21,6 g orangefarbene Kristalle mit einem Fp. von 172-173°C und $\lambda_{max}$= 349 nm (DMF).

1.1.3
Q = -O- ;

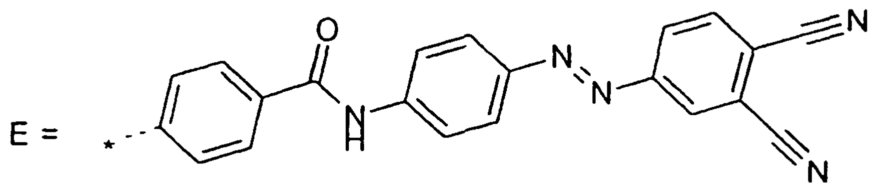

12 g 3,4-Dicyanoanilin werden analog 1.1.2 diazotiert. Man gibt langsam bei 0 bis 5°C die Reaktionsmischung zu einer Lösung von 6,5 g Anilin in 60 ml Eisessig und rührt bei Raumtemperatur über Nacht. Der Niederschlag wird abgesaugt, mit Wasser gewaschen und getrocknet. Man erhält 12 g rotes 4-Amino-3',4'-dicyano-azobenzol, das ohne Reinigung weiter verwendet wird. Die weitere Synthese des Monomers wird analog 1.1.1 durchgeführt. Das Monomer 1.1.3 hat einen Fp. von 160-161°C und $\lambda_{max}$= 392 nm (DMF).

1.1.4
Q = -O- ;

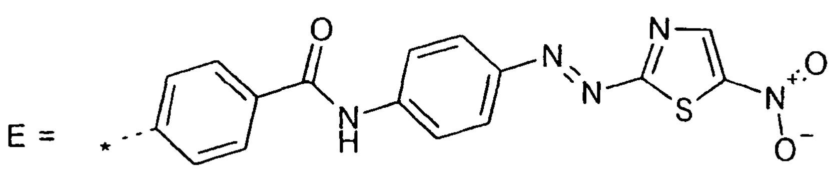

Dieses Monomer wird analog 1.1.3 hergestellt. Es zeigt einen Fp. von 207-208°C und $\lambda_{max}$= 456 nm (DMF).

1.1.5
Q = - $N(CH_3)$ - ;

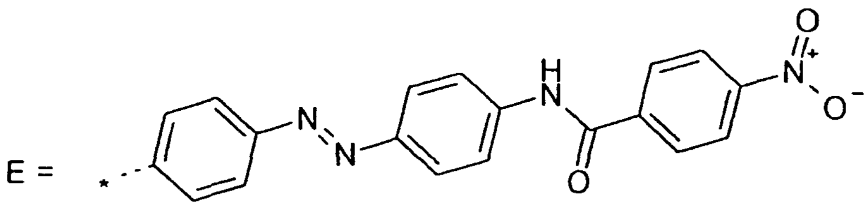

a) 38.6 g 4-(4-Nitrobenzoylamino)-anilin wurden in einer Mischung aus 207 ml Eisessig, 72 ml Propionsäure und 31 ml 30%-igcr Salzsäure gelöst. Bei 0-5 °C tropften während 1 h 49.7 g 40%-ige Nitrosylschwefelsäure dazu. Dann wurde 2 h bei 0-5 °C nachgerührt.

b) 32.8 g N-Methyl-N-(2-methacryloyloxy-ethyl)-anilin (Methode 1.1.6) wurden in 130 ml Eisessig gelöst. Bei 5-10 °C tropfte man die Diazotierungslösung aus a) innerhalb 1 h dazu, wobei durch Zutropfen von 20 %-iger wäßriger Sodalösung der pH-Wert auf 3 gehalten wurde. Über Nacht wurde bei Raumtemperatur und bei einem pH-Wert von 3 nachgerührt. Die Suspension wurde abgesaugt. Das noch feuchte Produkt wurde in 500 ml Wasser suspendiert. Durch Zugabe von 20 %-iger wäßriger Sodalösung wurde der pH-Wert auf 7 angehoben. Erneut wurde abgesaugt, mit 200 ml Wasser gewaschen und im Vakuum bei 50 °C getrocknet. Man erhielt 56.2 g (77 % d. Th.) orangefarbenes Pulver mit einem Fp. von 198°C . In DMF zeigte das Produkt ein Absorptionsmaximum bei 430 nm sowie eine Schulter bei 447 nm.

1.1.6
Q = - N($CH_3$) - ;

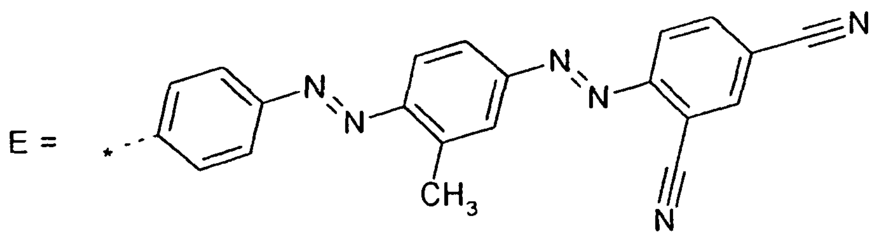

N-Methyl-N-(2-methacryloyloxy-ethyl)-anilin wird auf folgende Weise hergestellt:

- aus Methacrylchlorid:

  100 g N-Methyl-N-(2-hydroxyethyl)-anilin werden in 100 ml Chloroform gelöst. Man gibt bei 40°C unter Rühren tropfenweise 182,6 g Triethylamin und 137,2 g Methacrylchlorid langsam hinzu und rührt bei 40°C über Nacht. Danach versetzt man die Reaktionslösung mit 500 ml Chloroform und schüttelt 5 mal mit je 200 ml Wasser aus. Die organische Phase wird über wasserfreiem Magnesiumsulfat getrocknet, mit Kupfer(I) chlorid versetzt und nach Abdestillieren des Lösungsmittels im Hochvakuum destilliert. Der Methacrylester des Hydroxyethylanilins geht bei 127-130°C/55 mbar als wasserklare Flüssigkeit über. Die Ausbeute beträgt 49,5 g.

- aus Methacrylsäure:

  In eine Lösung aus 100 ml N-Methyl-N-(2-hydroxyethyl)-anilin, 265 ml Methacrylsäure und 26,5 g Hydrochinon in 398 ml Chloroform werden bei Raumtemperatur unter Rühren 50 ml konz. Schwefelsäure getropft. Nach dem Stehcn über Nacht wird aufgeheizt und das Reaktionswasser azeotrop entfernt. Nach dem Abkühlen wird mit konzentrierter wäßriger Sodalösung ein pH von 7 bis 8 eingestellt, und das Produkt wird aus dieser Lösung durch Ausschütteln mit Ether extrahiert. Man verfährt wie oben angegeben weiter und erhält eine Ausbeute von 56 g.

  2-Methyl-4-amino-2',4'-dicyanoazobenzol wird analog 1.1.3 aus 2,4-Dicyanoanilin und o-Toluidin synthetisiert. 4,1 g 2-Methyl-4-amino-2',4'-dicyanoazobenzol werden analog 1.1.2 diazotiert.

  Man gibt langsam die Reaktionsmischung zu einer Mischung von 3,5 g N-Methyl-N-(2-methacryloyloxy-ethyl)-anilin und 5 g Soda in 100 ml Methanol, wobei die Temperatur auf 10°C und der pH-Wert mit Soda auf 5 gehalten werden. Es fällt zunächst das orangefarbene Nebenprodukt aus, das abfiltriert wird. Danach versetzt man die Reaktionsmischung mit einer neuen Portion Soda. Nach einiger Zeit fällt ein violetter Niederschlag aus. Man filtriert ihn ab, wäscht mit Wasser und trocknet. Der feste Stoff wird danach in Diisopropylether gerührt, abfiltriert und getrocknet. Man erhält 2,1 g eines violetten Produktes mit einem Fp. von 163-165°C und $\lambda_{max}$= 536 nm (DMF).

1.1.7
Q = -O- ;

E = 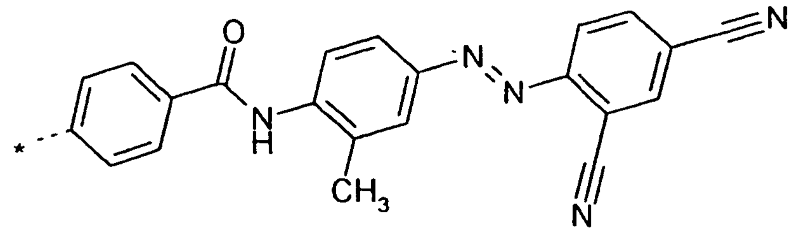

2-Methyl-4-amino-2',4'-dicyanoazobenzol (Methode 1.1.6) wird mit 4-(2-Methacryloyloxy)-ethoxy-benzoesäurechlorid analog 1.1.1 umgesetzt. Man erhält orangefarbene Kristalle mit einem Fp. von 182-184°C und $\lambda_{max}$= 389 nm (DMF).

1.1.8
Q = -O- ;

E = 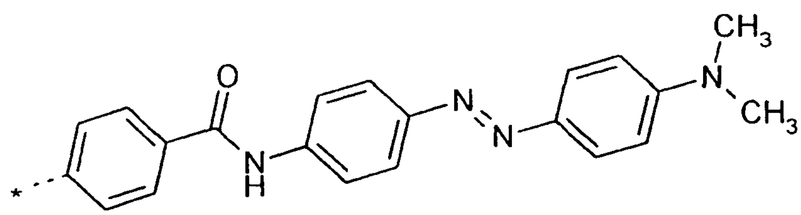

4-Amino-4'-dimethylaminoazobenzol wird mit 4-(2-Methacryloyloxy)-ethoxybenzoesäurechlorid analog 1.1.1 umgesetzt. Man erhält orangefarbene Kristalle mit einem Fp. von 218-220°C und $\lambda_{max}$= 428 nm (DMF).

1.1.9
Q = -O- ;

E = 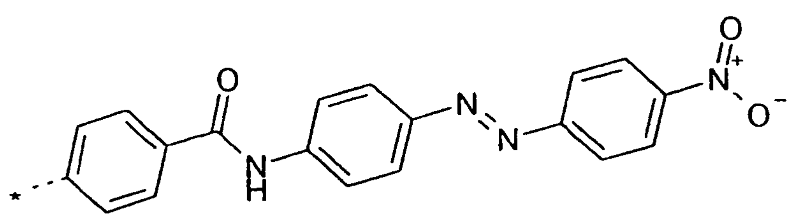

4-Amino-4'-nitroazobenzol (Disperse Orange 3) wird mit 4-(2-Methacryloyloxy)-ethoxy-benzocsäurechlorid analog 1.1.1 umgesetzt. Man erhält orangefarbene Kristalle mit einem Fp. von 202°C und $\lambda_{max}$= 391 nm (DMF).

1.1.10
Q = -O- ;

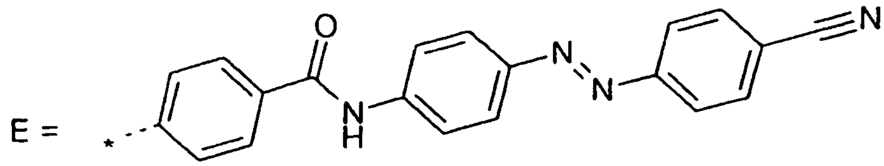

8,6 g 4-Cyanoanilin werden analog 1.1.2 diazotiert. Man gibt langsam bei 5 bis 10°C die Reaktionsmischung zu einer Lösung von 6,5 g Anilin und 3 g Harnstoff in 60 ml Wasser und rührt bei Raumtemperatur über Nacht. Der Niederschlag wird abgesaugt, mit Wasser gewaschen und getrocknet. Man erhält 6,9 g des orangefarbenen 4-Amino-4'-cyano-azobenzols, das ohne Reinigung weiter verwendet wird. Die weitere Synthese des Monomers wird analog 1.1.1 durchgeführt. Das Monomer 1.1.10 hat einen Fp. von 174 °C, eine flüssigkristalline Phase bis 204°C und $\lambda_{max}$= 380 nm (DMF).

1.1.11
Q = - N($CH_3$) - ;

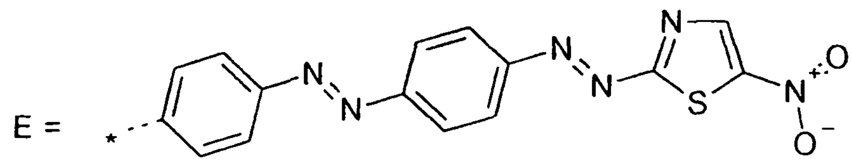

7 g 4-(5-Nitro-2-thiazolylazo)anilin (Methode 1.1.4) wird analog 1.1.2 diazotiert. Man gibt langsam die Reaktionsmischung zu einer Lösung von 6,2 g N-Methyl-N-(2-methacryloyloxy-ethyl)-anilin und 1 g Harnstoff in 30 ml Eisessig, wobei die Temperatur auf 10°C gehalten wird. Nach 1h Nachrühren wird die Reaktionsmischung auf Eis ausgetragen. Der Niederschlag wird abfiltriert, mit Wasser gewaschen und getrocknet. Man erhält 10,1 g dunkelblaue Kristalle mit einem Fp. von 207°C und $\lambda_{max}$= 589 nm (DMF).

1.1.12
Q = - N($CH_3$) - ;

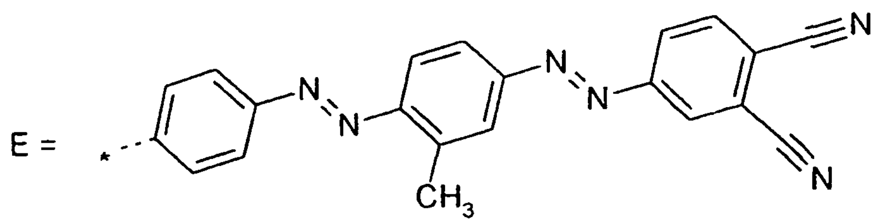

2-Methyl-4-amino-3',4'-dicyano-azobenzol (Methode 1.1.6) wird mit N-Methyl-N-(2-methacryloyloxy-ethyl)-anilin analog 1.1.11 umgesetzt. Man erhält violette Kristalle mit einem Fp. von 164 °C und $\lambda_{max}$= 521 nm (DMF).

1.1.13
Q = -O- ;

E = 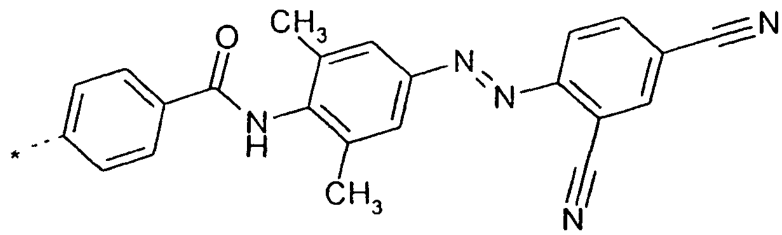

2,5-Dimethyl-4-amino-2',4'-dicyano-azobenzol wird analog 1.1.3 aus 2,4-dicyanoanilin und 2,5-Dimethylanilin synthetisiert.

Zu einer Lösung von 5,9 g 4-(2-Methacryloyloxy)-ethoxy-benzoesäurechlorid in 40 ml Dioxan werden 5,5 g 2,5-Dimethyl-4-amino-2',4'-dicyano-azobenzol in 200 ml Dioxan gegeben, 48 h unter Rühren am Rückfluß gekocht und das Produkt durch Eingießen der Lösung in 1 l Wasser gefällt. Der Niederschlag wird abgesaugt, getrocknet und durch zweimaliges Umkristallisieren aus Dioxan gereinigt. Die Ausbeute beträgt 6,0 g orangerote Kristalle mit einem Fp. von 200- 202°C. $\lambda_{max}$= 367,5 nm (DMF)

1.2 Herstellung des Homopolymerisats

7,9 g Monomer 1.1 werden in 75 ml DMF unter Argon als Schutzgas mit 0,39 g Azobis(isobutyronitril) als Polymerisationsinitiator bei 70°C zur Polymerisation gebracht. Nach 24 h wird filtriert, das DMF abdestilliert und der Rückstand zur Entfernung nicht umgesetzter Monomerer mit Methanol ausgekocht und bei 120°C im Hochvakuum getrocknet. Man erhält 7,18 g eines amorphen Polymerisats mit einer Glasübergangstemperatur von 150°C, dessen optische Eigenschaften in Beispiel 2.1.1 angegeben sind.
Zur Herstellung weiterer Polymerisate verfährt man analog.

**Beispiel 2** Erzeugung der lichtinduzierten Doppelbrechung

Herstellung der Meßproben: 2 x 2 cm große Glasplättchen der Dicke 1.1 mm werden in einem Spincoater (Bauart Süss RC 5) placiert und mit 0,2 ml einer Lösung von 150 g der nachfolgend angegebenen Polymerisate in 1 l absolutem Tetrahydrofuran bei 2000 U/min in 10 sec beschichtet. Die Schicht ist 0,9 µm dick, transparent und amorph. Zwischen gekreuzten Polarisatoren erscheint die Fläche bei Tageslicht gleichmäßig dunkel.

Die Meßplättchen werden mit einem Ar-Ionen Laser mit einer Leistung von 60, 120 oder 250 mW bei einer Wellenlänge von 514 nm belichtet, wobei sich eine Doppelbrechung aufbaut. Die maximal erreichbare Doppelbrechung $\Delta n$ in der Polymerschicht wird in zwei Schritten bestimmt:

Zuerst wird der maximale induzierbare Gangunterschied $\Delta\lambda$, der zwischen gekreuzten Polarisatoren eine Aufhellung erzeugt, durch eine Messung mit einem Ehringhaus-Kompensator bestimmt. Die quantitative Bestimmung erfolgt durch die Kompensation der Aufhellung. Dies geschieht durch Drehung eines in den Strahlengang gebrachten Quarzkristalls, der die optische Weglänge und damit den Gangunterschied ändert. Man ermittelt nun den Gangunterschied, bei dem die Aufhellung vollständig kompensiert wird. Die Messung muß mit Licht einer Wellenlänge vorgenommen werden, die außerhalb des Absorptionsbereichs der Verbindungen liegt, um Resonanzeffekte zu vermeiden. In der Regel genügt ein He-Ne-Laser der Emissionswellenlänge 633 nm, bei langwelligen Absorptionen wird mit Licht eines Diodenlasers der Wellenlänge 820 nm gemessen. Die verwendete Auslesewellenlänge ist in den folgenden Tabellen unter der Spaltenüberschrift "λ" angegeben.

In einem zweiten Schritt wird die Schichtdicke des Polymers mit einem mechanisch wirkenden Schichtdickenmeßjerät (Alphastep 200; Hersteller: Tencor Instruments) gemessen.

Die Doppelbrechungsänderung $\Delta n$ wird aus dem Quotienten des Gangunterschieds $\Delta\lambda$ und der Schichtdicke d bestimmt:

$$\Delta_n = \frac{\Delta_\lambda}{d}$$

Die Bestimmung der Absorptionsmaxima geschieht durch Auswerten der UV/Vis-Absorptionsspektren.

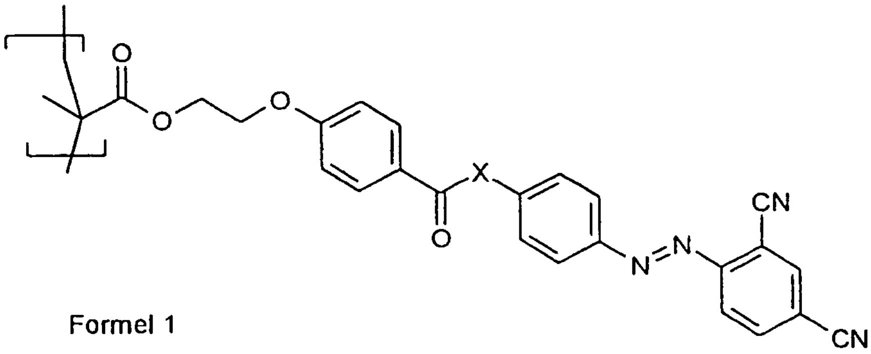

Formel 1

| Beispiel 2.1 | $\nu_A$ | $\Delta n$ | mW | $\lambda$ [nm] |
|---|---|---|---|---|
| 2.1.1 X=NH | 25380 | 0,278 | 60 | 633 |
| 2.1.2 X = O | 29200 | 0,134 | 60 | 633 |

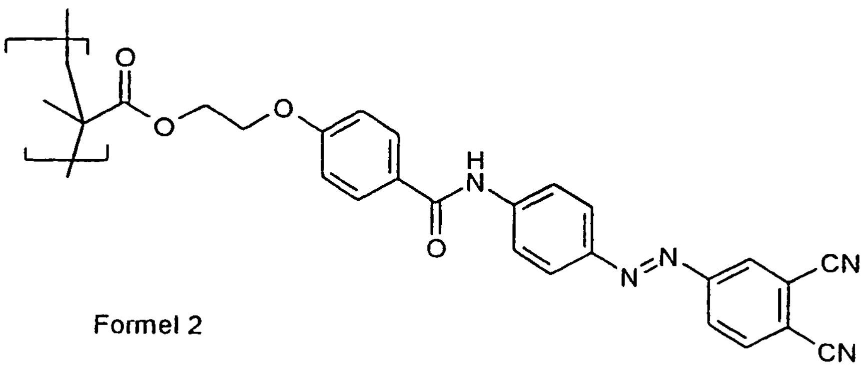

Formel 2

| Beispiel 2.2 | $\nu_A$ | $\Delta n$ | mW | $\lambda$ [nm] |
|---|---|---|---|---|
| | 26000 | 0,244 | 250 | 820 |

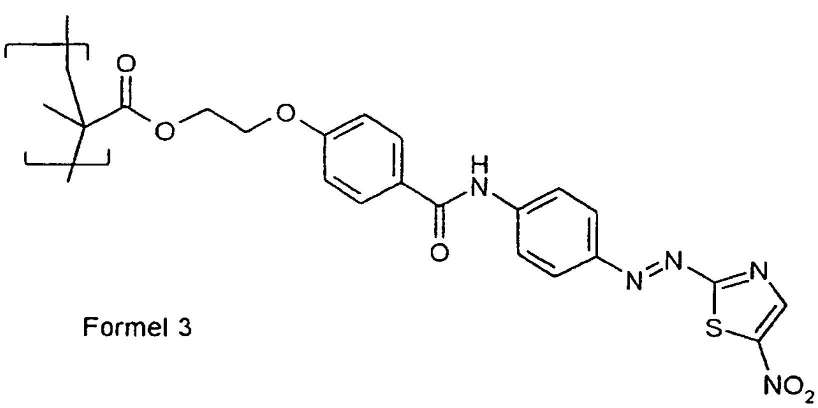

Formel 3

| Beispiel 2.3 | $\nu_A$ | Δn | mW | λ [nm] |
|---|---|---|---|---|
| | 23800 | 0,094 | 120 | 820 |

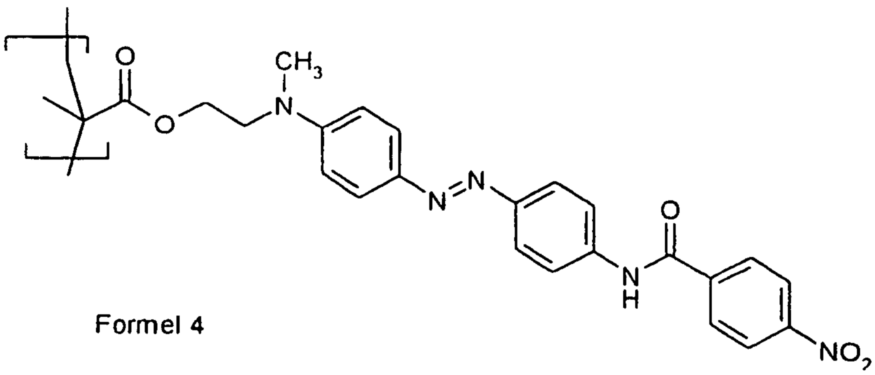

Formel 4

| Beispiel 2.4 | $\nu_A$ | Δn | mW | λ [nm] |
|---|---|---|---|---|
| | 20800 | 0,223 | 250 | 633 |

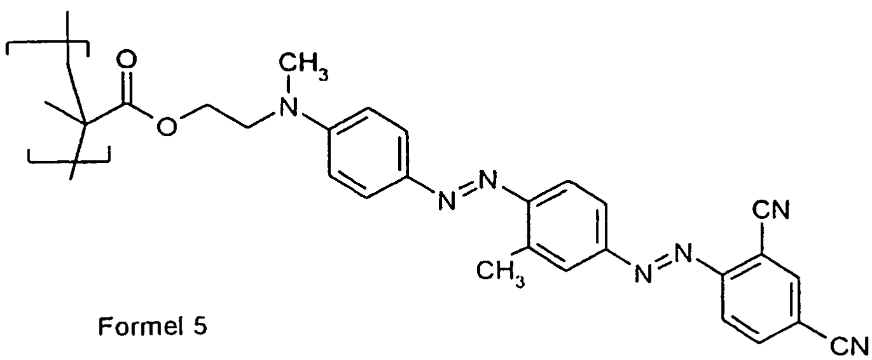

Formel 5

| Beispiel 2.5 | $\nu_A$ | Δn | mW | λ [nm] |
|---|---|---|---|---|
| | 27855; 19380 | 0,194 | 250 | 820 |

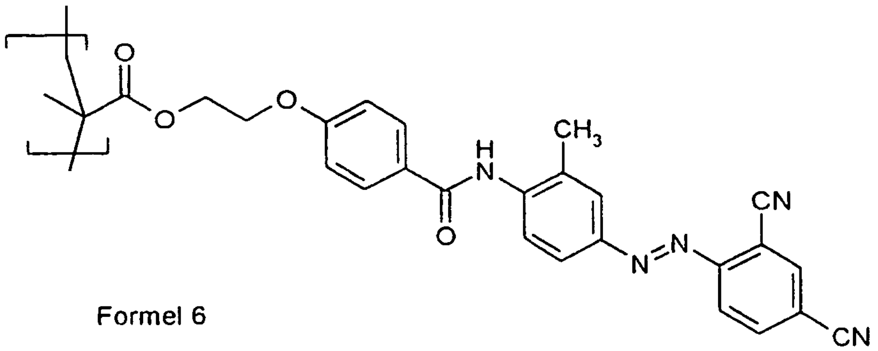

Formel 6

| Beispiel 2.6 | $\nu_A$ | $\Delta n$ | mW | $\lambda$ [nm] |
|---|---|---|---|---|
| | 26000 | 0,097 | 250 | 820 |

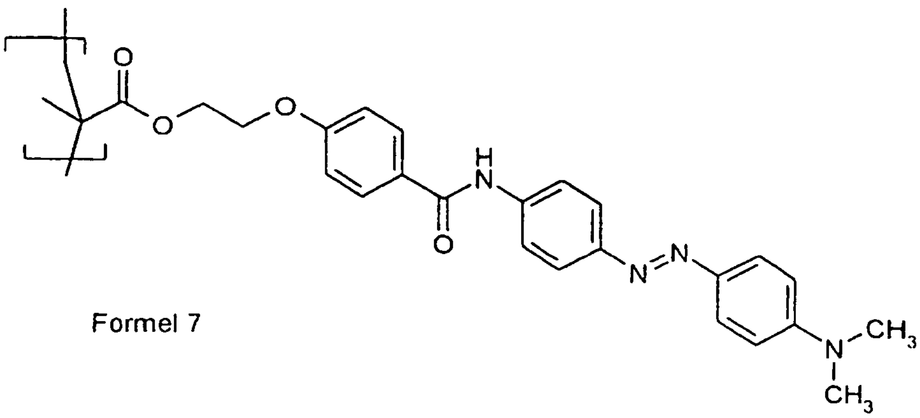

Formel 7

| Beispiel 2.7 | $\nu_A$ | $\Delta n$ | mW | $\lambda$ [nm] |
|---|---|---|---|---|
| | 25000 | 0,127 | 250 | 820 |

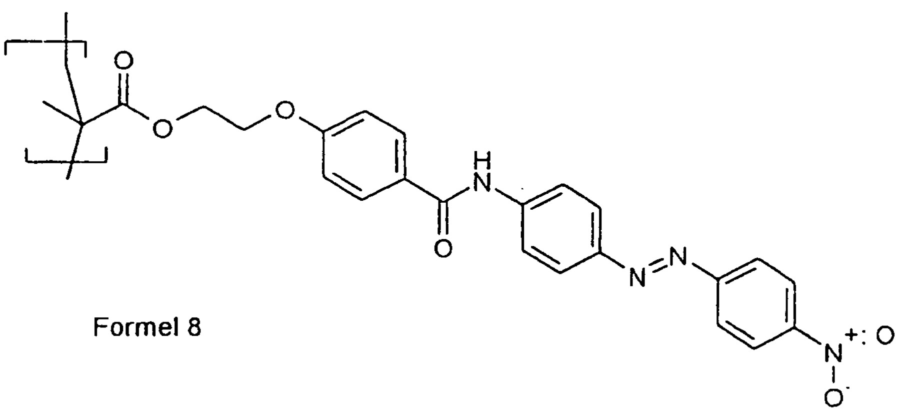

Formel 8

| Beispiel 2.8 | $\nu_A$ | $\Delta n$ | mW | $\lambda$ [nm] |
|---|---|---|---|---|
| | 27400 | 0,145 | 250 | 820 |

## Patentansprüche

**1.** Homopolymere aus Monomeren der Formel

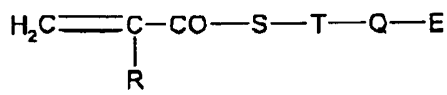

mit R = H oder Methyl,
die an einer als Rückgrat wirkenden Hauptkette davon abzweigende kovalent gebundene Seitengruppen der Formel

-S-T-Q-E

tragen, worin bedeuten:

S  Sauerstoff, Schwefel oder $NR^1$,

$R^1$  Wasserstoff oder $C_1$-$C_4$-Alkyl,

T  den Rest $(CH_2)_n$, der gegebenenfalls durch -O-, $-NR^1-$ oder $-OSiR^1{}_2O-$ unterbrochen und/oder gegebenenfalls durch Methyl oder Ethyl substituiert sein kann,

n  die Zahlen. 2, 3 oder 4,

Q  einen zweibindigen Rest und

E  eine mindestens dreikemige Gruppierung, wobei die Kerne ausgewählt sind aus der Gruppe von 2,6-Naphthylen, 1,4-Phenylen, heterocyclischen Resten der Strukturen

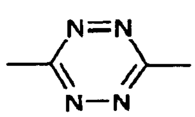 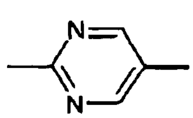 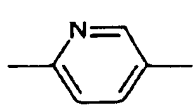 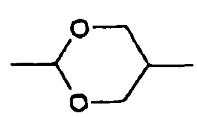

und 5-gliedrigen carbocyclischen oder heteroaromatischen Ringsystemen mit bis zu 3 Heteroatomen aus der Reihe S, N und O,
wobei die aromatischen Kerne ggf. durch $C_1$-$C_{12}$-Alkyl, $C_1$-$C_{12}$-Alkoxy, Hydroxy, Halogen (insbesondere F, Cl, Br), Amino, Nitro, Trifluormethyl, Cyan, Carboxy, COOR (R = $C_1$-$C_6$-Alkyl, Cyclohexyl, Benzyl, Phenyl), $C_5$-$C_{12}$-Cycloalkyl, $C_1$-$C_{12}$-Alkylthio, $C_1$-$C_6$-Alkylsulfonyl, $C_6$-$C_{12}$-Arylsulfonyl, Aminosulfonyl, $C_1$-$C_6$-Alkylaminosulfonyl, Phenylaminosulfonyl, Aminocarbonyl, $C_1$-$C_6$-Alkylaminocarbonyl, Phenylaminocarbonyl, $C_1$-$C_4$-Alkylamino, Di-$C_1$-$C_4$alkylamino, Phenylamino, $C_1$-$C_5$-Acylamino, $C_1$-$C_4$-Alkylsulfonylamino, Mono- oder Di- $C_1$-$C_4$-alkylaminocarbonylamino, $C_1$-$C_4$-Alkoxycarbonylamino oder Trifluormethylsulfonyl cin- oder mehrfach substituiert sind und
die heterocyclischen Kerne ggf. durch $C_1$-$C_{12}$-Alkyl, $C_1$-$C_{12}$-Alkoxy, Hydroxy, Halogen (insbesondere F, Cl, Br), Amino, Nitro, Trifluormethyl, Cyan, Carboxy, COOR (R = $C_1$-$C_6$-Alkyl, Cyclohexyl, Benzyl, Phenyl),

$C_5$-$C_{12}$-Cycloalkyl, $C_1$-$C_{12}$-Alkylthio, $C_1$-$C_6$-Alkylsulfonyl, $C_6$-$C_{12}$-Arylsulfonyl, Aminosulfonyl, $C_1$-$C_6$-Alkylaminosulfonyl, Plienylaminosulfonyl, Aminocarbonyl, $C_1$-$C_6$-Alkylaminocarbonyl, Phenylaminocarbonyl, $C_1$-$C_4$-Alkylamino, Di-$C_1$-$C_4$-alkylamino, Phenylamino, $C_1$-$C_5$-Acylamino, $C_1$-$C_4$-Allcylsulfonylamino, Mono- oder Di- $C_1$-$C_4$-alkylaminocarbonylamino, $C_1$-$C_4$-Alkoxycarbonylamino oder Trifluormethylsulfonyl ein- oder mehrfach substituiert sind,
und mindestens eine für eine photoinduzierte Konfigurationsänderung geeignete Kern-verbindende Gruppe der Formel

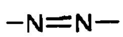 , 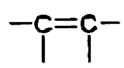 , 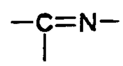 , 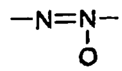 oder 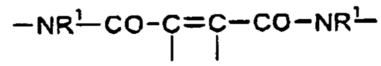

enthalten ist.

**2.** Verfahren zur Herstellung von Homopolymeren nach Anspruch 1, wonach man die Monomere homopolymerisiert.

**3.** Monomere der Formel

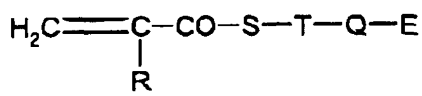

worin

R Wasserstoff oder Methyl bedeutet und

S, T, Q, E die Bedeutungen wie in Anspruch 1 besitzen.

**4.** Verwendung der Homopolymeren nach Anspruch 1 zur Herstellung von Folien und Beschichtungen.

**5.** Verwendung der Homopolymeren nach Anspruch 1 zur Herstellung optischer Bauelemente für optische Informationsspeicherung und für die Holographie.

**6.** Optische Bauelemente, hergestellt gemäß Anspruch 5.

## Claims

**1.** Homopolymers formed from monomers of the formula

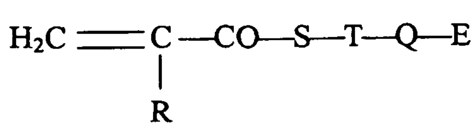

wherein R = H or methyl,
which, on a main chain acting as a backbone, carry covalently bound side groups which branch therefrom, of the formula

-S-T-Q-E

wherein

S denotes oxygen, sulphur or $NR^1$
$R^1$ denotes hydrogen or $C_1$-$C_4$ alkyl,
T denotes the radical $(CH_2)_n$, which can optionally be interrupted by -O-, $-NR^1$- or $-OSiR^1{}_2O$- and/or can optionally be substituted by methyl or ethyl,
n denotes the numbers 2, 3 or 4,
Q denotes a radical comprising two bonds and
E denotes an at least trinuclear grouping selected from

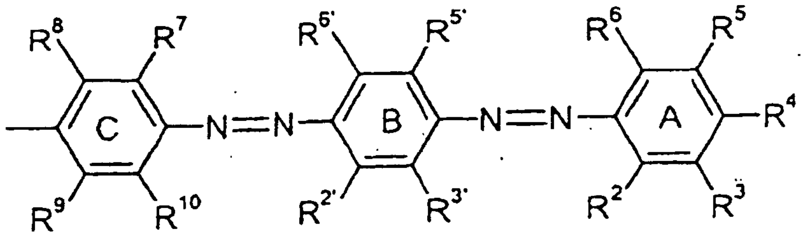

(V),

wherein

$R^2$ to $R^6$, independently of one another, denote hydrogen, chlorine, bromine, trifluoromethyl, $SO_2CH_3$, $SO_2CF_3$, $SO_2NH_2$, CN, 4-substituted benzamido or nitro, providing that at least two of these radicals are not hydrogen, wherein

$R^4$ can additionally denote a single bond and

$R^7$ to $R^{10}$, independently of one another, denote hydrogen, chlorine or methyl

and

$R^{2'}$ to $R^{6'}$ have the meanings of $R^2$ to $R^6$ - but independently therefrom

or

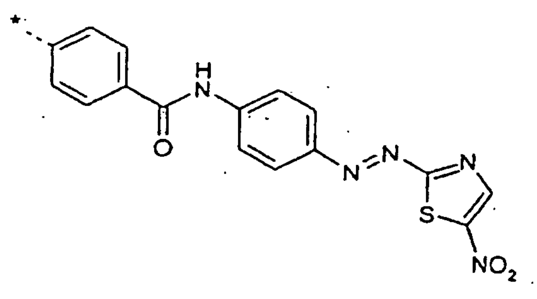

or

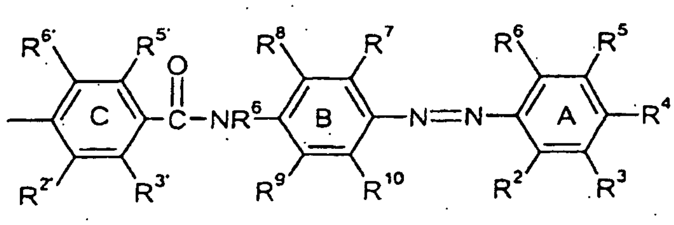

(VII)

wherein

$R^2$ to $R^{10}$ and $R^{2'}$ to $R^{6'}$ have the meaning defined under formula (V).

**2.** Process for producing homopolymers according to claim 1, wherein the monomers are homopolymerised.

**3.** Monomers of the formula

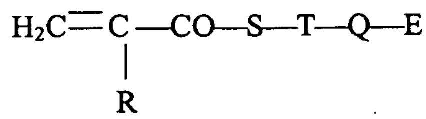

wherein

R denotes hydrogen or methyl and

S, T, Q, E have the meanings given in claim 1.

**4.** Use of the homopolymers according to claim 1 for the production of films and coatings.

**5.** Use of the homopolymers according to claim 1 for the production of optical components for the storage of optical information and for holography.

**6.** Optical components produced according to claim 6.

**Revendications**

**1.** Homopolymères constitués des monomères de formule :

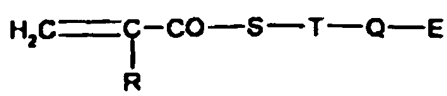

Avec R = H ou méthyle,

qui portent sur une chaîne principale agissant de squelette, des groupes latéraux liés de manière covalente, ramifiant celle-ci, de la formule :

-S-T-Q-E

où

S représente l'atome d'oxygène, de soufre ou le radical $NR^1$,

$R^1$ représente l'atome d'hydrogène ou un radical alkyle en $C_1$-$C_4$,

T représente le reste $(CH_2)_n$, qui peut être le cas échéant, interrompu par -O-, $-NR^1-$ ou $-OSiR^1{}_2O-$ et/ou être le cas échéant substitué, par le radical méthyle ou éthyle,

n représente les nombres 2, 3 ou 4,

Q représente un reste bivalent et

E représente un groupement au moins tricyclique, choisi parmi :

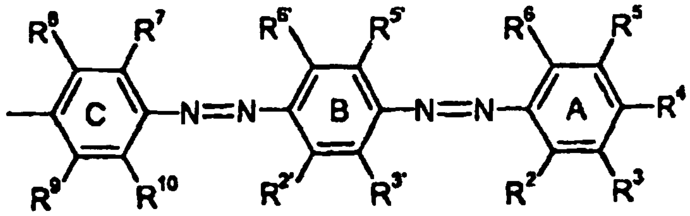 (V).

où

$R^2$ à $R^6$ représentent indépendamment l'un de l'autre, l'atome d'hydrogène, de chlore, de brome, le radical trifluorométhyle, $SO_2CH_3$, $SO_2CF_3$, $SO_2NH_2$, CN, benzamido substitué en 4 ou nitro, avec la condition qu'au moins deux de ces restes sont différents de l'atome d'hydrogène, où

$R^4$ peut représenter en outre, une simple liaison,

$R^7$ à $R^{10}$ représentent indépendamment l'un de l'autre, l'atome d'hydrogène, de chlore ou le radical méthyle, et

$R^{2'}$ à $R^{6'}$ possèdent les significations de $R^2$ à $R^6$, mais indépendamment de ceux-ci,

ou

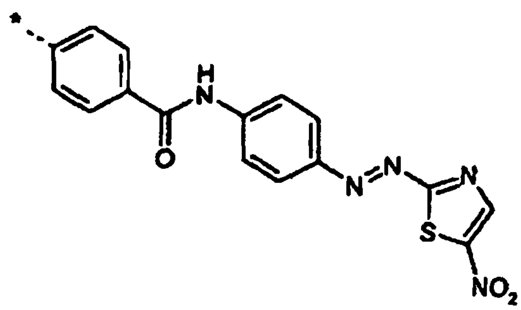

ou

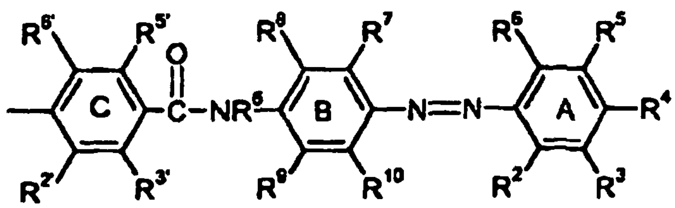 (VII)

où

$R^2$ à $R^{10}$ et $R^{2'}$ à $R^{6'}$ possèdent les significations définies à la formule (V).

**2.** Procédé de préparation d'homopolymères selon la revendication 1, où l'on réalise l'homopolymérisation des monomères.

**3.** Monomères de la formule :

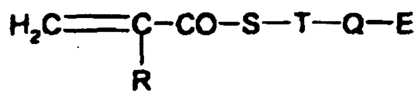

où

R représente l'atome d'hydrogène ou le radical méthyle,
S, T, Q, E possèdent les significations de la revendication 1.

**4.** Utilisation des d'homopolymères selon la revendication 1, pour la préparation de feuilles et revêtements.

**5.** Utilisation des d'homopolymères selon la revendication 1, pour la préparation d'éléments optiques pour l'enregistrement optique d'informations et pour l'holographie.

**6.** Elément optique, préparé selon la revendication 5.